# EUROPÄISCHE PATENTSCHRIFT

(11) **EP 1 770 792 B1**
(45) Veröffentlichungstag und Bekanntmachung des Hinweises auf die Patenterteilung: **28.09.2016**
(21) Anmeldenummer: 06016663.4
(22) Anmeldetag: 09.08.2006
(51) Int. Cl.: H01L 33/10, H01L 33/46, H01L 33/40

(54) **Strahlungsemittierender Halbleiterchip**
Radiation-emitting semiconductor chip
Puce à semi-conducteur émetteur de lumière

(30) Priorität: 29.09.2005 DE 102005046698; 01.02.2006 DE 102006004591
(43) Veröffentlichungstag der Anmeldung: 04.04.2007
(73) Patentinhaber: OSRAM Opto Semiconductors GmbH, 93055 Regensburg (DE)
(72) Erfinder: Wirth, Ralph, 93186 Pettendorf-Adlersberg (DE)
(74) Vertreter: Epping - Hermann - Fischer

(56) Entgegenhaltungen:
- EP-A2- 1 662 584
- DE-A1- 10 244 447
- DE-T2- 69 006 087
- US-A1- 2002 080 836
- US-A1- 2002 137 243

## Beschreibung

Strahlungsemittierender Halbleiterchip Die vorliegende Erfindung betrifft einen strahlungsemittierenden Halbleiterchip mit einem zur Strahlungserzeugung geeigneten aktiven Bereich.

Der Auskoppelwirkungsgrad eines derartigen Halbleiterchips, d.h. das Verhältnis der im aktiven Bereich erzeugten Strahlungsleistung zu der aus dem Chip ausgekoppelten Strahlungsleistung ist für die Effizienz derartiger Halbleiterchips von besonderer Bedeutung.

Derartige Halbleiterchips sind z.B. aus US2002/0137243 A1, oder US2002/0080836 A1 bekannt.

Eine Aufgabe der vorliegenden Erfindung ist es, einen, insbesondere hinsichtlich der Auskopplung, effizienten und vereinfacht herstellbaren Halbleiterchip anzugeben.

Diese Aufgabe wird durch einen Halbleiterchip mit den Merkmalen des Patentanspruchs 1 gelöst. Vorteilhafte Ausgestaltungen und Weiterbildungen der Erfindung sind Gegenstand der abhängigen Patentansprüche.

Ein erfindungsgemäßer strahlungsemittierender Halbleiterchip umfasst einen Dünnfilm-Halbleiterkörper, der eine Halbleiterschichtenfolge mit einem zur Strahlungserzeugung geeigneten aktiven Bereich aufweist, und eine auf dem Dünnfilm-Halbleiterkörper angeordnete Spiegelschicht. Zusätzlich zur Spiegelschicht weist der Halbleiterchip einen Braggspiegel auf, wobei der Braggspiegel und die Spiegelschicht auf der gleichen Seite des aktiven Bereichs angeordnet sind.

Der Braggspiegel und die Spiegelschicht können die in dem aktiven Bereich erzeugte Strahlung reflektieren. Der Braggspiegel oder alternativ die Spiegelschicht ist für die im aktiven Bereich erzeugte Strahlung bevorzugt teildurchlässig ausgeführt, sodass Strahlung durch den jeweils teildurchlässigen Spiegel hindurch treten und zu dem weiter von dem aktiven Bereich entfernten der beiden Spiegel gelangt und dort reflektiert werden kann. Bevorzugt ist der Braggspiegel zwischen dem aktiven Bereich und der Spiegelschicht angeordnet, da der Braggspiegel monolithisch in die Halbleiterschichtenfolge des Dünnfilm-Halbleiterkörpers, die beispielsweise epitaktisch auf einem Aufwachssubstrat gewachsen ist, monolithisch integriert sein kann.

Bevorzugt ist der Dünnfilm-Halbleiterkörper auf einem Träger angeordnet, wobei die Spiegelschicht besonders bevorzugt zwischen dem Träger und dem Dünnfilm-Halbleiterkörper angeordnet ist. Der Träger stabilisiert den Dünnfilm-Halbleiterkörper mit Vorteil mechanisch. Die Spiegelschicht kann auf den Dünnfilm-Halbleiterkörper aufgebracht sein. Der Braggspiegel ist bevorzugt zwischen dem aktiven Bereich und dem Träger angeordnet.

Die beiden Spiegel - die Spiegelschicht und der Braggspiegel - vermindern das Hindurchtreten von Strahlung auf die dem aktiven Bereich abgewandte Seite der beiden Spiegel. Die Absorption von Strahlung in auf dieser Seite der Spiegel angeordneten Elementen, z.B. einem absorbierenden Träger, kann so vermindert werden. Die Auskoppeleffizienz des Halbleiterchips wird in der Folge erhöht. Ferner wird durch Reflexion der Strahlung an den beiden Spiegeln der über eine den Spiegeln abgewandte Oberfläche des Dünnfilm-Halbleiterkörpers aus dem Halbleiterchip ausgekoppelte Anteil an Strahlungsleistung erhöht. Die spezifische Ausstrahlung des Halbleiterchips seitens dieser Oberfläche kann so vereinfacht erhöht werden. Unter spezifischer Ausstrahlung ist hierbei die aus der Oberfläche austretende Strahlungsleistung in Watt pro Flächeninhalt der Oberfläche in Quadratmeter zu verstehen.

Da der Halbleiterchip zwei Spiegel, den Braggspiegel und die Spiegelschicht, aufweist, können die Einzelspiegel mit verringertem Aufwand hergestellt werden, ohne dass die Auskoppeleffizienz des Halbleiterchips gegenüber einem Halbleiterchip mit genau einem Einzelspiegel auf einer Seite des aktiven Bereichs maßgeblich verringert wird. Für eine hohe Auskoppeleffizienz ist eine möglichst hohe Reflektivität eines Einzelspiegels, z.B. 95 % oder mehr, und eine damit einhergehende aufwendige Realisierung dieses Spiegels erforderlich.

Für einen hochreflektierenden Braggspiegel, z.B. mit einer Reflektivität von mehr als 95 % für senkrechten Strahlungseinfall, muss in der Regel eine Vielzahl von übereinander angeordneten Schichten, die den Braggspiegel bilden, vorgesehen werden. Die Reflektivität des Braggspiegels kann über die Anzahl an Schichten eingestellt werden. Die für eine vorgegebene Reflektivität benötigte Schichtzahl steigt stark nichtlinear mit wachsender vorgegebener Reflektivität. Je größer die Schichtanzahl ist, desto höher ist jedoch der Herstellungsaufwand bzw. desto höher sind die Herstellungskosten, z.B. aufgrund der verlängerten Epitaxiezeiten.

Da erfindungsgemäß zwei Spiegel vorgesehen sind, können der Braggspiegel und die Spiegelschicht mit vergleichsweise geringen Einzelreflektivitäten ausgebildet werden. Die vergleichsweise geringe Einzelreflektivität des ersten Spiegels kann über Reflexion am zweiten Spiegel, dem Braggspiegel bzw. der Spiegelschicht, zumindest teilweise kompensiert werden. Die Gesamtreflektivität der beiden Spiegel kann mit vorteilhaft geringem Aufwand Werte im Bereich der Reflektivität eines hochreflektierenden Einzelspiegels erreichen. Der Halbleiterchip ist demnach bei hoher Auskoppeleffizienz vereinfacht und kostengünstig herstellbar.

Der Braggspiegel kann für die im aktiven Bereich erzeugte Strahlung eine Reflektivität von 90 % oder weniger, bevorzugt 80 % oder weniger, besonders bevorzugt 70 % oder weniger aufweisen. Derartige Reflektivitäten können mit vertretbarem Aufwand und vergleichsweise kostengünstig erzielt werden. Auch die Spiegelschicht kann dementsprechende Reflektivitäten aufweisen. Weiterhin ist die Reflektivität des Braggspiegels bevorzugt 50 % oder größer, besonders bevorzugt 60 % oder größer. Die Spiegelschicht weist bevorzugt eine Reflektivität von 70 % oder größer, besonders bevorzugt 80 % oder größer auf.

Die Gesamtreflektivität eines die beiden Spiegel umfassenden "Gesamtspiegels" ist bevorzugt 80 % oder größer, besonders bevorzugt 90 % oder größer oder insbesondere 95 % oder größer.

In einer bevorzugten Ausgestaltung enthält die Spiegelschicht ein Metall. Eine metallhaltige Spiegelschicht zeichnet sich gegenüber einem Braggspiegel durch verringerte Abhängigkeit der Reflektivität vom Einfallswinkel der Strahlung zur Oberflächennormalen der Spiegelschicht aus. Auch unter vergleichsweise großen Winkeln zur Oberflächennormalen der Spiegelschicht auf diese treffende Strahlung kann so zuverlässig reflektiert werden. Insbesondere kann durch den Braggspiegel hindurch tretende Strahlung, die in erhöhtem Maße Anteile mit vergleichsweise großen Einfallswinkeln aufweist, im Wesentlichen unabhängig vom Einfallswinkel reflektiert werden.

Bevorzugt ist die Spiegelschicht im Wesentlichen metallisch ausgeführt oder enthält eine Legierung, die mindestens ein Metall enthält. Geeignete Metalle sind z.B. Au, Al, Ag oder Pt, geeignete Legierungen, die bevorzugt mindestens eines der zuvor genannten Metalle enthalten, sind z.B. AuGe oder AuSn. Eine metallhaltige Spiegelschicht kann auf den Dünnfilm-Halbleiterkörper, beispielsweise mittels Aufdampfen, aufgebracht sein.

Weiterhin ist die Spiegelschicht bevorzugt elektrisch leitend ausgeführt. Der Halbleiterchip kann in diesem Falle mittels der Spiegelschicht vereinfacht elektrisch kontaktiert werden. Zweckmäßigerweise ist die Spiegelschicht hierfür elektrisch leitend mit dem aktiven Bereich verbunden.

Der Braggspiegel ist bevorzugt dotiert ausgeführt, sodass auch der Braggspiegel aufgrund der erhöhten Leitfähigkeit vereinfacht an der elektrischen Kontaktierung des Halbleiterchips beteiligt sein kann. Über den Braggspiegel und die elektrisch leitende Spiegelschicht können dem aktiven Bereich Ladungsträger zur Strahlungserzeugung über Ladungsträgerrekombination im aktiven Bereich zugeführt werden.

In einer weiteren bevorzugten Ausgestaltung ist die Spiegelschicht großflächig, insbesondere vollflächig und/oder direkt, elektrisch leitend mit dem Dünnfilm-Halbleiterkörper verbunden. Eine großflächige Ladungsträgerinjektion in den aktiven Bereich über die Spiegelschicht wird so erleichtert. In der Folge kann aufgrund der vorteilhaft großen Injektionsfläche die im Halbleiterchip erzeugte Strahlungsleistung vereinfacht erhöht werden.

Erfindungsgemäß ist zwischen der Spiegelschicht und dem Braggspiegel eine Halbleiterkontaktschicht angeordnet. Mittels der Halbleiterkontaktschicht können die elektrischen Kontakteigenschaften zwischen der Spiegelschicht und dem Dünnfilm-Halbleiterkörper, der vorzugsweise unmittelbar an die Spiegelschicht angrenzt, optimiert werden. Auf diese Weise kann vereinfacht ein, insbesondere im Wesentlichen barrierefreier, ohmscher Kontakt zwischen der Spiegelschicht und dem Dünnfilm-Halbleiterkörper ausgebildet werden. Die Halbleiterkontaktschicht kann verglichen mit den Schichten des Braggspiegels vergleichsweise frei gewählt werden. Der Braggspiegel grenzt bevorzugt unmittelbar an die Halbleiterkontaktschicht an.

Eine Spiegelschicht, die zur elektrischen Kontaktbildung zum Dünnfilm-Halbleiterkörper geeignet ist, zeichnet sich jedoch nicht notwendigerweise durch hohe Reflektivitäten für die erzeugte Strahlung aus. Aufgrund des zusätzlichen Braggspiegels kann die Spiegelschicht vereinfacht auf elektrische Kontakteigenschaften hin optimiert werden, ohne die Auskoppeleffizienz des Halbleiterchips, z. B. wegen einer vergleichsweise geringen Reflektivität der kontaktbildenden Spiegelschicht, maßgeblich zu mindern.

Ferner kann die Spiegelschicht aufgrund des zusätzlichen Braggspiegels ohne maßgebliche Effizienzminderung vereinfacht auf weitere oder alternative Funktionen hin optimiert ausgeführt werden. Beispielsweise kann die Spiegelschicht als Verbindungsschicht ausgebildet sein, mittels derer der Dünnfilm-Halbleiterkörper, vorzugsweise mechanisch stabil, auf dem Träger befestigt ist. Die Verbindungsschicht kann hinsichtlich geeigneter Befestigungseigenschaften, etwa der Haftung zum Träger und/oder zum Dünnfilm-Halbleiterkörper, optimiert sein. Zum Beispiel ist die Verbindungsschicht als Lotschicht ausgeführt.

Ist die Spiegelschicht als Verbindungsschicht ausgeführt, so grenzt sie bevorzugt unmittelbar an den Träger und/oder den Dünnfilm-Halbleiterkörper an. Auf aufwendige Bondmetallisierungen zum Befestigen des Dünnfilm-Halbleiterkörpers auf dem Träger zusätzlich zur Spiegelschicht kann mit Vorteil verzichtet werden. Der Dünnfilm-Halbleiterkörper kann demnach mittels einer Einzelschicht, die als Spiegelschicht und Verbindungsschicht ausgeführt ist, auf dem Träger befestigt sein.

In einer weiteren bevorzugten Ausgestaltung ist der Abstand des aktiven Bereichs vom Braggspiegel größer als der Abstand des aktiven Bereichs von einer dem Braggspiegel oder dem Träger abgewandten Oberfläche des Dünnfilm-Halbleiterkörpers.

Der Anteil an direkt, d.h. ohne Totalreflexion im Dünnfilm-Halbleiterkörper oder Reflexion an einem der beiden Spiegel, über die den Spiegeln abgewandte Oberfläche des Dünnfilm-Halbleiterkörpers aus dem Dünnfilm-Halbleiterkörper ausgekoppelter Strahlungsleistung kann so erhöht werden.

In einer weiteren bevorzugten Ausgestaltung ist der Halbleiterchip resonatorfrei, insbesondere nicht als Laser oder RCLED (Resonant Cavity Light Emitting Diode), betrieben bzw. ist der Halbleiterchip zum resonatorfreien Betrieb vorgesehen. Der Halbleiterchip ist weiterhin zur Erzeugung inkohärenter Strahlung, insbesondere als LED-Chip, ausgebildet.

Bei Halbleiterchips mit einem Resonator, etwa einem Laserchip zur Erzeugung kohärenter Strahlung oder einer RCLED zur Erzeugung inkohärenter Strahlung, wird oftmals nur eine vergleichsweise kleine Teilfläche einer Oberfläche des Chips zur Emission genutzt. Bei einem LED-Chip ohne Resonator dagegen kann mit Vorteil im Wesentlichen die gesamte, dem Braggspiegel bzw. der Spiegelschicht abgewandte Oberfläche des Halbleiterkörpers zur Emission genutzt werden.

Als Dünnfilm-Halbleiterkörper kann im Rahmen der Erfindung ein Halbleiterkörper angesehen werden, der frei von einem Herstellungssubstrat ist, auf dem die Halbleiterschichtenfolge des Dünnfilm-Halbleiterkörpers hergestellt ist. Bei der Herstellung der Halbleiterschichtenfolge durch epitaktisches Aufwachsen ist das Herstellungssubstrat beispielsweise durch das Aufwachssubstrat gegeben. Der Träger des Dünnfilm-Halbleiterkörpers, der diesen bevorzugt mechanisch stabilisiert, ist vom Herstellungssubstrat verschieden. Ein Substrat für die Herstellung einer Halbleiterschichtenfolge unterliegt in der Regel hohen Anforderungen, z.B. an die für das Aufwachsen dargebotene Kristalloberfläche des Aufwachssubstrats. Da der Träger des Dünnfilm-Halbleiterkörpers vom Herstellungssubstrat verschieden ist, kann er vergleichsweise frei gewählt werden, ohne die für die Herstellung der Halbleiterschichtenfolge erforderlichen Eigenschaften aufweisen zu müssen. Beispielsweise kann der Träger hinsichtlich thermischer oder elektrischer Leitfähigkeit optimiert gewählt werden. Die Effizienz des Halbleiterchips kann so gesteigert werden.

In einer bevorzugten Ausgestaltung ist das Herstellungssubstrat, auf dem die Halbleiterschichtenfolge für den Dünnfilm-Halbleiterkörper gefertigt ist, von der Halbleiterschichtenfolge entfernt, z.B. abgelöst. Besonders bevorzugt wird die Halbleiterschichtenfolge hierbei vor dem Ablösen des Herstellungssubstrats auf dem Träger angeordnet und befestigt. Das Herstellungssubstrat kann so, ohne die Gefahr einer Schädigung der Halbleiterschichtenfolge zu erhöhen von der Halbleiterschichtenfolge entfernt werden, wobei die mechanische Stabilität der Halbleiterschichtenfolge durch den Träger gewährleistet wird. Für das Entfernen des Herstellungssubstrats eignet sich beispielsweise Ätzen, Wasserstrahlschneiden oder ein Laserablöseverfahren.

Die Spiegelschicht wird vorzugsweise vor dem Entfernen des Herstellungssubstrats von der Halbleiterschichtenfolge auf die dem Herstellungssubstrat abgewandte Oberfläche der Halbleiterschichtenfolge aufgebracht, z.B. aufgedampft.

Zur Befestigung auf dem Träger kann zwischen der Halbleiterschichtenfolge und dem Träger eine Verbindungsschicht ausgebildet sein. Diese Verbindungsschicht ist vorzugsweise metallhaltig, z.B. eine Lotschicht. Die Verbindungsschicht kann, wie weiter oben bereits erwähnt, zugleich als Spiegelschicht des Halbleiterchips dienen. Alternativ kann die Verbindungsschicht zusätzlich zur Spiegelschicht vorgesehen sein. In diesem Falle ist die Spiegelschicht bevorzugt zwischen der Verbindungsschicht und dem Dünnfilm-Halbleiterkörper angeordnet.

Ein strahlungsemittierender Halbleiterchip mit einem Braggspiegel und einer zusätzlichen Spiegelschicht, die beide auf der gleichen Seite des aktiven Bereichs angeordnet sind, emittiert einen vorteilhaft hohen Anteil an in dem aktiven Bereich erzeugter Strahlungsleistung über die den Spiegeln abgewandte Oberfläche des Dünnfilm-Halbleiterkörpers. Die Strahldichte, d.h. die ausgesandte Strahlungsleistung in Watt (W) pro Raumwinkel in Steradiant (sr) und pro einer vom Empfänger der Strahlung aus sichtbaren Emissionsfläche des Halbleiterchips in Quadratmeter (m²), kann so vereinfacht erhöht werden. Hierbei ist das Abstrahlprofil des Halbleiterchips, d.h. die Winkelabhängigkeit der abgestrahlten Strahlungsleistung, gegenüber einem Halbleiterchip, bei dem auf den Braggspiegel verzichtet ist, bevorzugt im wesentlichen unverändert. Der Braggspiegel weist zwar nominell die höchste Reflektivität im Bereich um seine Oberflächennormale auf, so dass eine Konzentration der austretenden Strahlungsleistung im Bereich um die Oberflächennormale erwartet werden könnte, nach der Reflexion am Braggspiegel aber wird die reflektierte Strahlung durch Brechung im Halbleiterkörper aufgeweitet, so dass das Abstrahlprofil der aus dem Halbleiterchip ausgekoppelten Strahlung aufgrund des zusätzlichen Braggspiegels im wesentlichen nicht verändert wird.

Weiterhin reflektiert der Braggspiegel bevorzugt Strahlung innerhalb eines von dem aktiven Bereich, insbesondere einem Zentrum des aktiven Bereichs, ausgehend auf den Braggspiegel gerichteten Auskoppelkegels. Der Auskoppelkegel ist hierbei ein Kegel, dessen Öffnungswinkel von dem aktiven Bereich in Richtung des Braggspiegels gleich dem doppelten Grenzwinkel der Totalreflexion für den Strahlungsaustritt aus dem Halbleiterchip ist. Außerhalb eines Auskoppelkegels verlaufende Strahlung unterliegt einer fortgesetzten Totalreflexion im Halbleiterkörper und trägt daher nicht oder nur in sehr geringem Maße zur ausgekoppelten Strahlungsleistung bei.

Ein Dünnfilm-Halbleiterchip, d.h. ein Halbleiterchip mit einem Dünnfilm-Halbleiterkörper, der auf einem Träger angeordnet ist, kann sich weiterhin durch zumindest eines der folgenden Merkmale auszeichnen:
- an einer zu dem Träger hin gewandten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20*µ*m oder weniger, insbesondere im Bereich von 10 *µ*m auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Halbleiterchip mit einer Spiegelschicht zwischen dem Dünnfilm-Halbleiterkörper und dem Träger emittiert Strahlung im Wesentlichen über die dem Träger abgewandte Oberfläche des Dünnfilm-Halbleiterkörpers. Aufgrund des zusätzlichen Braggspiegels, der auf der gleichen Seite des aktiven Bereichs wie die Spiegelschicht angeordnet ist, kann eine Spiegelschicht vergleichsweise geringer Reflektivität eingesetzt werde, ohne dass die über die dem Träger abgewandte Oberfläche des Dünnfilm-Halbleiterkörpers ausgekoppelte Strahlungsleistung wesentlich verringert wird. Weiterhin wird die Abstrahlcharakteristik des Dünnfilm-Halbleiterchips trotz des vorgesehenen Braggspiegels gegenüber derjenigen eines Dünnfilm-Chips mit einer hochreflektierenden Spiegelschicht nicht oder nicht wesentlich modifiziert.

Weitere Merkmale, Vorteile und Zweckmäßigkeiten der Erfindung ergeben sich aus der folgenden Beschreibung der Ausführungsbeispiele in Verbindung mit den Figuren.
Figur 1 zeigt eine schematische Schnittansicht eines Ausführungsbeispiels eines erfindungsgemäßen strahlungsemittierenden Halbleiterchips und
Figur 2 zeigt eine schematische Schnittansicht eines Ausführungsbeispieles eines nicht erfindungsgemäßen strahlungsemittierenden Halbleiterchips. Gleiche, gleichartige und gleichwirkende Elemente sind in den Figuren mit gleichen Bezugszeichen versehen.

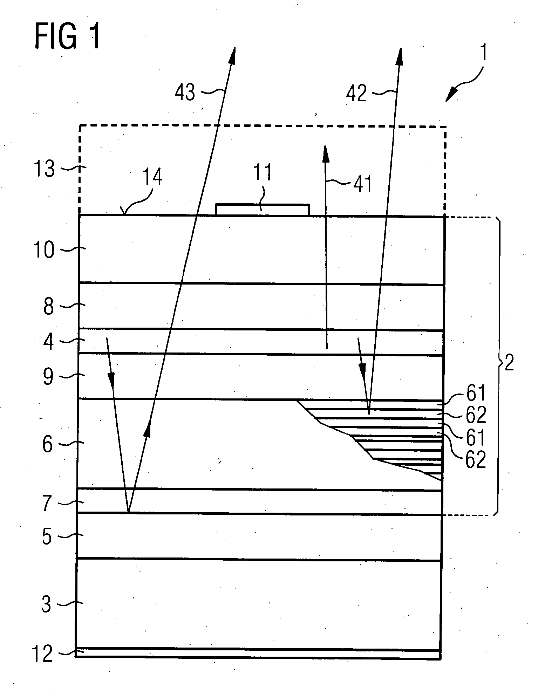

Figur 1 zeigt eine schematische Schnittansicht eines Ausführungsbeispiels eines erfindungsgemäßen strahlungsemittierenden Halbleiterchips.

Der strahlungsemittierende Halbleiterchip 1 umfasst einen Dünnfilm-Halbleiterkörper 2, der auf einem Träger 3 angeordnet ist. Der Dünnfilm-Halbleiterkörper 2 weist eine Halbleiterschichtenfolge mit einem zur Strahlungserzeugung geeigneten aktiven Bereich 4 auf. Zwischen dem Dünnfilm-Halbleiterkörper 2 und dem Träger 3 ist eine Spiegelschicht 5 angeordnet. Zusätzlich zur Spiegelschicht ist im Dünnfilm-Halbleiterkörper 2 zwischen der Spiegelschicht 5 und dem aktiven Bereich 4 ein Braggspiegel 6 monolithisch integriert. Zwischen dem Braggspiegel 6 und der Spiegelschicht 5 ist ferner eine Halbleiterkontaktschicht 7 angeordnet.

Der aktive Bereich 4 ist zwischen einer ersten Mantelschicht 8 und einer zweiten Mantelschicht 9 ausgebildet, wobei die erste Mantelschicht auf der dem Braggspiegel 6 abgewandten Seite des aktiven Bereichs 4 und die zweite Mantelschicht zwischen dem aktiven Bereich 4 und dem Braggspiegel 6 angeordnet ist.

Auf der dem Braggspiegel 6 gegenüberliegenden Seite des aktiven Bereichs 4 ist eine Stromaufweitungsschicht 10 angeordnet, die vorzugsweise im Dünnfilm-Halbleiterkörper 2 monolithisch integriert ist. Bevorzugt schließt die Stromaufweitungsschicht 10 den Dünnfilm-Halbleiterkörper 2 auf dessen dem Braggspiegel 6 abgewandten Seite ab. Seitens der Spiegelschicht 5 wird der Dünnfilm-Halbleiterkörper 2 bevorzugt durch die Halbleiterkontaktschicht 7 begrenzt.

Auf der der Spiegelschicht 5 abgewandten Seite des Dünnfilm-Halbleiterkörpers 2 ist ein erster Anschluss 11 angeordnet, der zusammen mit einem auf der dem Dünnfilm-Halbleiterkörper 2 abgewandten Seite des Trägers 3 angeordneten zweiten Anschluss 12 zur externen elektrischen Kontaktierung des Halbleiterchips 1 vorgesehen ist. Der erste Anschluss 11 kann für eine Bonddrahtverbindung und der zweite Anschluss 12 für eine Lötverbindung zur elektrischen Kontaktierung des Halbleiterchips vorgesehen sein.

Der Dünnfilm-Halbleiterkörper 2 ist von einem Aufwachssubstrat 13, auf dem die Halbleiterschichtenfolge für den Dünnfilm-Halbleiterkörper epitaktisch gewachsen wurde, befreit. Das Aufwachssubstrat der Halbleiterschichtenfolge, die den Dünnfilm-Halbleiterkörper bilden kann, ist von der Halbleiterschichtenfolge entfernt, insbesondere abgelöst. Für das Entfernen eignet sich z.B. Ätzen, Wasserstrahlschneiden oder ein Laserablöseverfahren.

Vor dem Entfernen des Aufwachssubstrats 13 wird die Halbleiterschichtenfolge für den Dünnfilm-Halbleiterkörper 2 bevorzugt auf dem vom Aufwachssubstrat verschiedenen Träger 3 angeordnet und befestigt. Der Träger 3 stabilisiert den Dünnfilm-Halbleiterkörper 2 auch nach dem Entfernen des Aufwachssubstrats 13 mechanisch. Die Halbleiterschichtenfolge für den Dünnfilm-Halbleiterkörper 2 wird zweckmäßigerweise mit ihrer dem Aufwachssubstrat abgewandten Seite auf dem Träger angeordnet. Das entfernte Aufwachssubstrat 13 ist in Figur 1 gestrichelt angedeutet.

Die Spiegelschicht 5 wird bevorzugt vor dem Anordnen der Halbleiterschichtenfolge auf dem Träger 3 auf die dem Aufwachssubstrat 13 abgewandte Seite der Halbleiterschichtenfolge aufgebracht, z.B. aufgedampft. Der Träger 3 kann verglichen mit dem Aufwachssubstrat 13 vergleichsweise frei, beispielsweise hinsichtlich thermischer und/oder elektrische Leitfähigkeit optimiert, gewählt werden. Ein Dünnfilm-Halbleiterchip mit dem auf dem Träger 3 angeordneten Dünnfilm-Halbleiterkörper 2 ist somit für die Ausbildung eines effizienten strahlungsemittierenden Halbleiterchips besonders geeignet.

Der Braggspiegel 6 umfasst bevorzugt eine Mehrzahl von Halbleiterschichtenpaaren, die jeweils eine erste Halbleiterschicht 61 und eine zweite Halbleiterschicht 62 aufweisen. Diese Halbleiterschichten weisen bevorzugt einen vorteilhaft hohen Brechungsindexunterschied auf, sodass die zum Erreichen einer vorgegebenen Reflektivität des Braggspiegels erforderliche Anzahl an Halbleiterschichtenpaaren vorteilhaft gering ist. Weiterhin sind die Halbleiterschichten bevorzugt als λ/4-Schichten für die im aktiven Bereich erzeugte Strahlung der Wellenlänge λ ausgeführt. Die Halbleiterschichten 61 und 62 verschiedener Halbleiterschichtenpaare sind im Braggspiegel 6 zweckmäßigerweise alternierend angeordnet.

Der erste und der zweite Anschluss 11 bzw. 12, die beispielsweise jeweils ein Metall enthalten oder als Metallisierung ausgeführt sind, sind mit dem aktiven Bereich 4 elektrisch leitend verbunden, sodass über diese Anschlüsse Ladungsträger in den aktiven Bereich injiziert werden, die dort unter Strahlungserzeugung rekombinieren können.

Die Spiegelschicht 5 und/oder der Träger 3 sind bevorzugt elektrisch leitend ausgeführt, um die elektrische Kontaktierung des Halbleiterchips 1 zu erleichtern. Die Spiegelschicht ist hierzu bevorzugt metallisch ausgeführt oder enthält eine Legierung. Geeignete Metalle sind z.B. Au, Al, Ag, Pt, geeignete Legierungen sind z.B. AuGe oder AuSn.

Die außerhalb des aktiven Bereichs, der bevorzugt intrinsisch, d.h. undotiert, ausgeführt ist, im Dünnfilm-Halbleiterkörper angeordnete Schichten sind zur Erhöhung der elektrischen Leitfähigkeit vorzugsweise dotiert. Insbesondere ist der Braggspiegel bevorzugt dotiert ausgeführt. Zwischen dem Träger 3 und dem aktiven Bereich 4 angeordnete Schichten weisen bevorzugt den gleichen Leitungstyp auf (n-leitend oder p-leitend). Entsprechendes gilt bevorzugt für die auf der den Spiegeln gegenüberliegenden Seite des aktiven Bereichs angeordneten Schichten des Dünnfilm-Halbleiterkörpers, wobei der Leitungstyp besonders bevorzugt nach dem Überschreiten des aktiven Bereichs wechselt.

Die zwischen der Spiegelschicht 5 und dem Braggspiegel 6 angeordnete Halbleiterkontaktschicht 7, die bevorzugt unmittelbar an die Spiegelschicht und besonders bevorzugt an den Braggspiegel angrenzt, zeichnet sich zweckmäßigerweise durch vorteilhafte elektrische Kontakteigenschaften zur elektrisch leitfähigen Spiegelschicht 5 aus. Insbesondere kann die Halbleiterkontaktschicht 7 derart ausgeführt sein, dass eine Potentialbarriere zwischen der Spiegelschicht 5 und dem Dünnfilm-Halbleiterkörper 2 gegenüber einem Dünnfilm-Halbleiterkörper, bei dem auf die Halbleiterkontaktschicht verzichtet ist, verringert ist. Die Halbleiterkontaktschicht 7 kann vergleichsweise dünn, z.B. mit einer Dicke zwischen einschließlich 20 nm und einschließlich 100 nm, ausgeführt sein.

Die Spiegelschicht 5 ist bevorzugt im Wesentlichen vollflächig und besonders bevorzugt direkt elektrisch leitend mit dem Dünnfilm-Halbleiterkörper 2 verbunden. Auf das Ausbilden vergleichsweise aufwendiger Kontaktstrukturen, etwa aufwendiger Metallisierungsschichtenfolgen, zwischen dem Dünnfilm-Halbleiterkörper 2 und der Spiegelschicht 5 kann so verzichtet werden. Weiterhin wird auf diese Weise eine großflächige Bestromung des aktiven Bereichs erleichtert und im aktiven Bereich 4 kann vereinfacht eine hohe Strahlungsleistung erzeugt werden.

Die Stromaufweitungsschicht 10 weist mit Vorzug eine vergleichsweise hohe Querleitfähigkeit - die Leitfähigkeit in lateraler Richtung - auf. Über den ersten Anschluss 11, der nur einen vergleichsweise geringen Anteil der Oberfläche 14 überdeckt, in den Dünnfilm-Halbleiterkörper 2 injizierter Strom kann so in der Stromaufweitungsschicht gegenüber der vom ersten Anschluss überdeckten Fläche lateral verbreitert und, bevorzugt im Wesentlichen vollflächig, in den aktiven Bereich injiziert werden. Auf diese Weise kann vereinfacht ein vergleichsweise großer Teil des aktiven Bereichs, insbesondere im Wesentlichen der gesamte aktive Bereich, zur Strahlungserzeugung genutzt werden, obwohl seitens der Oberfläche 14 nur über eine vergleichsweise geringe Fläche unterhalb des ersten Anschlusses 11 Ladungsträger in den Dünnfilm-Halbleiterkörper 2 injiziert werden. Aufgrund der Stromaufweitungsschicht 11 kann der erste Anschluss 11 vereinfacht vorteilhaft kleinflächig ausgeführt werden, sodass die Gefahr einer Absorption von Strahlung in dem auf der Oberfläche 14 des Halbleiterchips 1 angeordneten ersten Anschluss 11 verringert ist. Bevorzugt weist die monolithisch in den Dünnfilm-Halbleiterkörper 2 integrierte Stromaufweitungsschicht 10 eine Dicke von 500 nm oder mehr, z.B. 700 nm oder mehr, auf. Bevorzugt ist die Dicke kleiner oder gleich 5 *µ*m.

Statt einer Halbleiter-Stromaufweitungsschicht kann auch eine nicht monolithisch in den Dünnfilm-Halbleiterkörper 2 integrierte Schicht zur Stromaufweitung eingesetzt werden. Hierzu ist eine Stromaufweitungsschicht, die ein strahlungsdurchlässiges elektrisch leitfähiges Oxid (TCO: Transparent Conduction Oxide), vorzugsweise ein Metalloxid, z.B. ein Zinnoxid, wie ZnO, oder ein Indiumzinnoxid enthält, besonders geeignet. TCO-Materialien zeichnen sich durch hohe Strahlungsdurchlässigkeit bei gleichzeitig hoher Querleitfähigkeit aus. Eine derartige Stromaufweitungsschicht ist zur Erhöhung der Leitfähigkeit bevorzugt dotiert, beispielsweise mit Al bei einer ZnO-haltigen Stromaufweitungsschicht.

Im Betrieb des Halbleiterchips 1 wird im aktiven Bereich 4 Strahlung erzeugt. Dies ist durch die Strahlungsanteile 41, 42 und 43 verdeutlicht. Die Mantelschichten 8 und 9, sind vorzugsweise als Barriereschichten, die die Ladungsträger im aktiven Bereich 4 einschließen und so die Wahrscheinlichkeit einer strahlenden Rekombination von Ladungsträgern im aktiven Bereich 4 erhöhen, ausgeführt.

Der Strahlungsanteil 41 tritt direkt über die den Spiegeln 5 und 6 abgewandte Oberfläche 14 des Dünnfilm-Halbleiterkörpers 2 aus diesem aus. Der Strahlungsanteil 42 trifft zunächst auf den Braggspiegel 6, wird an diesem reflektiert und verlässt den Dünnfilm-Halbleiterkörper 2 über die Oberfläche 14. Der Strahlungsanteil 43 tritt durch den Braggspiegel 6 hindurch, wird an der Spiegelschicht 5 reflektiert und tritt nach nochmaligem Durchtritt durch den Braggspiegel über die Oberfläche 14 aus dem Dünnfilm-Halbleiterkörper 2 aus. Die Oberfläche 14 bildet insbesondere die Hauptemissionsoberfläche des Halbleiterchips 1.

Aufgrund der Mehrzahl an Spiegeln, dem Braggspiegel 6 und der Spiegelschicht 5, ist die spezifische Ausstrahlung des Halbleiterchips 1 auf der Oberfläche 14 vorteilhaft erhöht. Der Halbleiterchip ist insbesondere als oberflächenemittierender Halbleiterchip ausgeführt, der den größten Teil an Strahlungsleistung, insbesondere 90 % oder mehr, über seine Hauptemissionsoberfläche emittiert.

Mittels der metallhaltigen Spiegelschicht 5, deren Reflektivität im Gegensatz zu der des Braggspiegels 6 weitgehend unabhängig vom Einfallswinkel der auftreffenden Strahlung ist, können auch Strahlungsanteile, die unter vergleichsweise großen Winkeln auf die Spiegelschicht treffen, wie etwa der Strahlungsanteil 43, vermehrt in Richtung der Oberfläche 14 gelenkt werden.

Dadurch, dass durch den Braggspiegel 6 tretende Strahlung an der Spiegelschicht 5 reflektiert werden kann, kann der Braggspiegel, ohne die Auskoppeleffizienz oder die ausgekoppelte Strahlungsleistung, von Strahlung, insbesondere über die Oberfläche 14, maßgeblich zu mindern mit vergleichsweise geringer Reflektivität, vorzugsweise 90% oder weniger, beispielsweise zwischen einschließlich 70 % und einschließlich 90 % bei senkrechtem Strahlungseinfall, d.h. parallel zur Oberflächennormalen des Braggspiegels, ausgeführt sein.

Die Epitaxiezeiten zur Herstellung des Dünnfilm-Halbleiterkörpers 2 mit dem integrierten Braggspiegel 6 und dementsprechend die Herstellungskosten können so verringert werden. Da der Braggspiegel 6 bereits einen Großteil der Strahlung reflektiert, kann auch die Spiegelschicht 5 eine vergleichsweise geringe Reflektivität, vorzugsweise 90% oder weniger, beispielsweise zwischen einschließlich 80 % und einschließlich 90 %, ausgeführt sein, ohne die Effizienz des Halbleiterchips maßgeblich zu verringern.

Die Spiegelschicht 5 kann demnach Materialien enthalten oder aus Materialien bestehen, die für die im aktiven Bereich 4 erzeugte Strahlung eine vergleichsweise geringe Reflektivität aufweisen, wie beispielsweise Au im grünen Spektralbereich. Die Freiheitsgrade bei der Auswahl von Materialien für die Spiegelschicht 5 sind so vorteilhaft erhöht.

Die Spiegelschicht 5 kann insbesondere vereinfacht hinsichtlich optimierter elektrischer Kontakteigenschaften zum Dünnfilm-Halbleiterkörper 2 ausgewählt werden und/oder als Verbindungsschicht, mittels derer der Dünnfilm-Halbleiterkörper auf dem Träger 3 befestigt ist, ausgebildet sein.

Bevorzugt grenzt die Spiegelschicht 5 hierzu, insbesondere vollflächig, direkt an den Dünnfilm-Halbleiterkörper 2 und den Träger 3 an. Die Spiegelschicht 5 ist beispielsweise als Lotschicht, etwa AuSn-Schicht, oder als einlegierte Kontaktmetallisierung, wie eine AuGe-Schicht, ausgeführt.

Da derartige Schichten zweckmäßigerweise hinsichtlich der Befestigungseigenschaften für eine Verbindungsschicht bzw. der elektrischen Kontakteigenschaften für eine kontaktbildende Schicht optimiert sind, weisen sie in der Regel eine vergleichsweise geringe Reflektivität für die im aktiven Bereich erzeugte Strahlung auf. Dies kann im Rahmen der Erfindung durch den Braggspiegel zumindest teilweise kompensiert werden. Auch da die Spiegelschicht zugleich als Verbindungsschicht dienen kann, kann der Halbleiterchip gegenüber einer separaten Ausbildung einer Spiegelschicht und einer Verbindungsschicht bei trotzdem hoher Auskoppeleffizienz vereinfacht und kostengünstig hergestellt werden.

In einer bevorzugten Ausgestaltung der Erfindung enthält der Dünnfilm-Halbleiterkörper, insbesondere der aktive Bereich, der Braggspiegel, die Halbleiterkontaktschicht und/oder die Stromaufweitungsschicht, ein III-V-Halbleitermaterial besonders bevorzugt ein Material aus den III-V Halbleitermaterialsystemen InₓGa_{y}Al_{1-x-y}P, mit 0≤x≤1, 0≤y≤1 und x+y≤1, vorzugsweise y≠0 und/oder y≠1, InₓGa_{y}Al_{1-x-y}As, mit 0≤x≤1, 0≤y≤1 und x+y≤1, vorzugsweise y≠0 und/oder y≠1, und/oder InₓGa_{y}Al_{1-x-y}N, mit 0≤x≤1, 0≤y≤1 und x+y≤1, vorzugsweise y≠0 und/oder y≠1.

Mittels Materialien aus diesen III-V-Materialsystemen kann ein für die Strahlungserzeugung besonders effizienter Halbleiterchip, insbesondere ein aktiver Bereich mit hoher Quanteneffizienz, gefertigt werden. Besonders geeignet sind derartige Materialien, insbesondere aus den Materialsystemen InₓGa_{y}Al_{1-x-y}P oder InₓGa_{y}Al_{1-x-y}N, zur Strahlungserzeugung im sichtbaren Spektralbereich. Bevorzugt ist der Halbleiterchip daher zur Erzeugung sichtbaren Lichts ausgebildet.

Weiterhin ist der Halbleiterchip 1 bevorzugt als LED-Chip zur Erzeugung inkohärenter Strahlung ausgebildet. Ferner ist der Halbleiterchip bevorzugt zum resonatorfreien Betrieb vorgesehen und insbesondere bevorzugt nicht als RCLED-Chip ausgebildet. Auf eine aufwendige abgestimmte Positionierung des aktiven Bereichs in einem Resonator, die für einen effizienten Betrieb eines Chips mit Resonator oftmals erforderlich ist, kann so verzichtet werden. Der aktive Bereich 4 kann also im Wesentlichen frei im Dünnfilm-Halbleiterkörper 2 angeordnet werden. Bevorzugt ist der aktive Bereich - abweichend von der rein schematischen Darstellung in Figur 1, die nicht maßstabsgetreu ausgeführt ist - näher an der den Spiegeln 5 und 6 abgewandten Oberfläche 14 des Dünnfilm-Halbleiterkörpers 2 angeordnet als an dem Braggspiegel 6. Die unmittelbar über die Oberfläche 14 austretende Strahlungsleistung kann so erhöht werden. Eine oder mehrere der zwischen der Spiegelschicht 5 und dem aktiven Bereich 4 angeordneten Schichten des Dünnfilm-Halbleiterkörpers 2 werden hierzu bevorzugt entsprechend dick ausgeführt.

Für einen Halbleiterchip 1, dessen aktiver Bereich 4 auf InₓGa_{y}Al_{1-x-y}P basiert, kann der Dünnfilm-Halbleiterkörper 2 beispielsweise die in der unten stehenden Reihenfolge auf einem GaAs-Aufwachssubstrat 13 aufgebrachte Halbleiterschichtenfolge aufweisen:

Eine n-leitende Stromaufweitungsschicht 10 die InGaAlP oder AlGaAs enthält. Im letzteren Falle ist der Aluminiumgehalt bevorzugt ≥ 0,5. Hierdurch können vorteilhaft hohe Querleitfähigkeiten erzielt werden. Eine n-leitende Mantelschicht 8, die InAlP enthält, einen aktiven Bereich 4, der InGaAlP enthält und eine p-leitende Mantelschicht 9, die InAlP enthält. Einen Braggspiegel 6 mit einer Mehrzahl von Halbleiterschichtenpaaren, beispielsweise zwischen einschließlich 5 und einschließlich 20 Halbleiterschichtenpaaren, bevorzugt zwischen 8 und 15 Halbleiterschichtenpaaren, besonders bevorzugt 10 Paaren, mit jeweils einer ersten λ/4-Halbleiterschicht 61, die Al_{0,5}Ga_{0,5}As enthält, und einer zweiten λ/4-Halbleiterschicht 62, die Al_{0,95}Ga_{0,05}As enthält. Der Braggspiegel ist zweckmäßigerweise p-leitend ausgeführt. Auf dem Braggspiegel ist eine p-leitende Halbleiterkontaktschicht 7 angeordnet, die auf AlₓGa₁₋ₓAs, mit 0 ≤ x ≤ 1, basiert. Ein Aluminiumgehalt von 0,5 oder weniger hat sich als für eine elektrische Kontaktbildung besonders vorteilhaft erwiesen. Gegenüber Schichten mit höherem Aluminiumgehalt kann hierbei eine Oxidation der Schicht, die die elektrischen Kontakteigenschaften verschlechtern kann, vermindert oder vermieden werden. Besonders geeignet ist eine Halbleiterkontaktschicht 7 aus Al_{0,5}Ga_{0,5}As oder GaAs, insbesondere zur elektrischen Kontaktbildung zu AuGe. Bevorzugt ist die Halbleiterkontaktschicht 7 vergleichsweise dünn, z.B. mit einer Dicke von 100 nm oder weniger, ausgeführt.

Gegebenenfalls können die Leitungstypen der einzelnen Schichten des Halbleiterkörpers auch jeweils vertauscht - von n-leitend nach p-leitend bzw. umgekehrt - sein.
Dies ist insbesondere dann zweckmäßig, falls eine TCO-Stromaufweitungsschicht 10, etwa aus ZnO:Al, vorgesehen ist, die sich besonders zur Kontaktbildung zu p-leitendem Material eignet.

Halbleitermaterialien aus den Untermaterialsystemen In_{0,5}(Ga₁₋ₓAlₓ)_{0,5}P und AlₓGa₁₋ₓAs, jeweils mit 0 s x s 1, zeichnen sich durch gute Gitteranpassung aneinander und insbesondere auch an GaAs aus. Bevorzugt basiert der Halbleiterchip daher auf diesen Materialsystemen. Schichten aus diesen Materialsystemen sind vereinfacht monolithisch integrierbar und vereinfacht aufeinander herstellbar. Eine Schicht aus dem AlₓGa₁₋ₓAs-System eignet sich besonders für zu metallhaltigen Materialien kontaktbildende Schicht oder als Schicht für den Braggspiegel. Der Brechungsindex einer AlₓGa₁₋ₓAs-Schicht kann über den Aluminiumgehalt x eingestellt werden, was für den Braggspiegel von besonderer Bedeutung ist. Diese Halbleiterschichtenfolge für den Dünnfilm-Halbleiterkörper 2 kann mittels einer AuGe-Spiegelschicht 5, die auf der Halbleiterkontaktschicht 7 ausgebildet wird, auf einem Ge-Träger 3 befestigt werden. Nachfolgend kann das Aufwachssubstrat 13 entfernt werden. AuGe zeichnet sich einerseits durch gute Befestigungseigenschaften und andererseits durch eine vorteilhaft hohe Reflektivität, insbesondere in dem Wellenlängenbereich zwischen einschließlich 560 nm und einschließlich 650 nm, aus. Zur Erzeugung von Strahlung in diesem Wellenlängenbereich ist das Materialsystem InₓGa_{y}Al_{1-x-y}P für einen entsprechenden aktiven Bereich besonders geeignet.

Die Spiegelschicht enthält bevorzugt ein Materialgefüge, welches ein Eutektikum aufweist. Besonders bevorzugt ist die Spiegelschicht in eutektischer Zusammensetzung ausgeführt. Auch hierfür ist AuGe in eutektischer Zusammensetzug besonders geeignet. Die Befestigung des Dünnfilm-Halbleiterkörpers 2 auf dem Träger 3 ist bei einer eutektischen Zusammensetzung der Spiegelschicht besonders temperaturstabil.

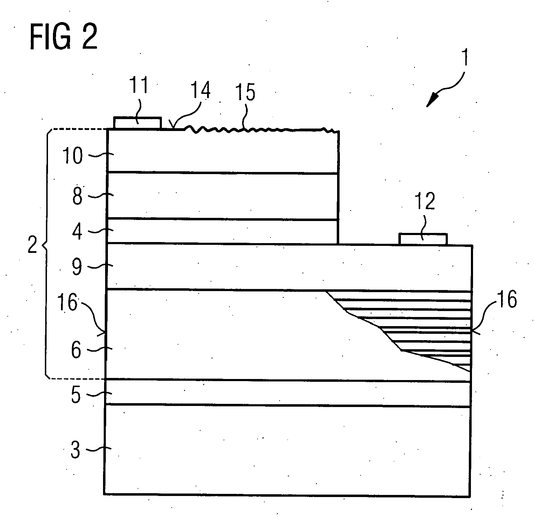

Figur 2 zeigt eine schematische Schnittansicht eines Ausführungsbeispieles eines nicht erfindungsgemäßen strahlungsemittierenden Halbleiterchips. Im Wesentlichen entspricht der Halbleiterchip 1 dem im Zusammenhang mit Figur 1 erläuterten Halbleiterchip.

Im Unterschied hierzu sind sowohl der erste Anschluss 11 als auch der zweite Anschluss 12 auf der dem Braggspiegel 6 und der Spiegelschicht 5 abgewandten Seite des Dünnfilm-Halbleiterkörpers 2 angeordnet. Der zweite Anschluss 12 ist direkt elektrisch leitend mit dem Bereich des Dünnfilm-Halbleiterkörpers zwischen der Spiegelschicht 5 und dem aktiven Bereich 4 verbunden. Bevorzugt sind sowohl der erste Anschluss 11 als auch der zweite Anschluss 12 für eine Drahtbondung vorgesehen. Um eine elektrisch leitende Verbindung des zweiten Anschlusses 12 zum zwischen dem aktiven Bereich 4 und der Spiegelschicht 5 angeordneten Bereich des Dünnfilm-Halbleiterkörpers 2 zu erleichtern, weist dieser Bereich bevorzugt eine laterale Ausdehnung auf, die größer ist als diejenige des auf der der Spiegelschicht 5 gegenüberliegenden Seite des aktiven Bereichs 4 angeordneten Bereichs des Dünnfilm-Halbleiterkörpers 2. Die Anordnung des zweiten Anschlusses 12 auf einer Schicht des Dünnfilm-Halbleiterkörpers 2 zwischen dem aktiven Bereich 4 und dem Braggspiegel 6, z.B. auf der zweiten Mantelschicht 9, wird so erleichtert.

Da die elektrische Kontaktierung auf der der Spiegelschicht 5 abgewandten Seite des Dünnfilm-Halbleiterkörpers erfolgt, kann der Träger 3 vereinfacht elektrisch isolierend ausgeführt sein. Auf eine Halbleiterkontaktschicht 7 wie im Ausführungsbeispiel gemäß Figur 1 wurde verzichtet, da die elektrische Kontaktierung nicht über die Spiegelschicht 5 erfolgt und eine gute elektrische Anbindung der Spiegelschicht 5 an den Dünnfilm-Halbleiterkörper 2 somit keine wesentlichen Vorteile mit sich bringt. Der Dünnfilm-Halbleiterkörper 2 wird seitens der Spiegelschicht 5 durch den Braggspiegel 6 begrenzt, der vorzugsweise direkt an die Spiegelschicht 5 angrenzt.

Weiterhin weist der Halbleiterchip 1 im Unterschied zum Ausführungsbeispiel gemäß Figur 1 eine Auskoppelstruktur 15 auf, die auf die Oberfläche 14 aufgebracht ist oder die in der Oberfläche 14 des Dünnfilm-Halbleiterkörpers ausgebildet ist. Die Auskoppelstruktur 15 ist bevorzugt nur in dem Teilbereich der Oberfläche 14, die auch im Ausführungsbeispiel gemäß Figur 2 als Hauptemissionsoberfläche dient, vorgesehen, der nicht vom ersten Anschluss überdeckt ist. Eine entsprechende Auskoppelstruktur 15 kann natürlich auch im Ausführungsbeispiel gemäß Figur 1 vorgesehen sein.

Beispielsweise ist die Auskoppelstruktur 15 als Aufrauung der Oberfläche 14 des Dünnfilm-Halbleiterkörpers 2, etwa als in der Stromaufweitungsschicht 10 ausgebildete Struktur, ausgeführt. Mittels der Auskoppelstruktur kann die Totalreflexion an der Oberfläche 14 gestört werden und die aus dem Dünnfilm-Halbleiterkörper 2 über die Oberfläche 14 ausgekoppelte Strahlungsleistung erhöht werden. Eine derartige Auskoppelstruktur kann beispielsweise mittels Ätzen oder eines Sandstrahlverfahrens erzeugt sein. Die Seitenflächen 16 des Dünnfilm-Halbleiterkörpers 2 sind bevorzugt frei von einer Auskoppelstruktur, so dass die Totalreflexion gezielt nur an der Oberfläche 14 gestört wird. Diese Patentanmeldung beansprucht die Prioritäten der deutschen Patentanmeldungen DE 10 2005 046 698.2 vom 29. September 2005 und DE 10 2006 004 591.2 vom 1. Februar 2006.

Die Erfindung ist nicht durch die Beschreibung anhand der Ausführungsbeispiele beschränkt. Vielmehr umfasst die Erfindung jedes Merkmal sowie jede Kombination von Merkmalen, wie in den Patentansprüchen beansprucht, auch wenn dieses Merkmal oder diese Kombination selbst nicht explizit in den Ausführungsbeispielen angegeben ist.

## Patentansprüche

1. Strahlungsemittierender Halbleiterchip (1) mit einem Dünnfilm-Halbleiterkörper (2), der eine Halbleiterschichtenfolge mit einem zur Strahlungserzeugung geeigneten aktiven Bereich (4) aufweist, und einer auf dem Dünnfilm-Halbleiterkörper angeordneten Spiegelschicht (5), wobei der Halbleiterchip einen Braggspiegel (6) aufweist, der Braggspiegel und die Spiegelschicht auf der gleichen Seite des aktiven Bereichs angeordnet sind, und wobei der Halbleiterchip (1) zur Erzeugung inkohärenter Strahlung ausgebildet ist,
**dadurch gekennzeichnet dass** eine Halbleiterkontaktschicht (7) zwischen der Spiegelschicht (5) und dem Braggspiegel (6)angeordnet ist.

2. Halbleiterchip nach Anspruch 1,
wobei der Braggspiegel (6) monolithisch in die Halbleiterschichtenfolge des Dünnfilm-Halbleiterkörpers (2) integriert ist.

3. Halbleiterchip nach Anspruch 1 oder 2,
wobei der Dünnfilm-Halbleiterkörper (2) auf einem Träger (3) angeordnet ist und die Spiegelschicht (5) zwischen dem Träger und dem Dünnfilm-Halbleiterkörper angeordnet ist.

4. Halbleiterchip nach Anspruch 3,
wobei der Braggspiegel (6) zwischen dem aktiven Bereich (4) und dem Träger (3) angeordnet ist.

5. Halbleiterchip nach mindestens einem der vorhergehenden Ansprüche,
wobei der Braggspiegel (6) zwischen dem aktiven Bereich (4) und der Spiegelschicht (5) angeordnet ist.

6. Halbleiterchip nach mindestens einem der vorhergehenden Ansprüche,
wobei der Halbleiterchip (1) frei von einem Aufwachssubstrat (13) der Halbleiterschichtenfolge des Dünnfilm-Halbleiterkörpers (2) ist.

7. Halbleiterchip nach mindestens einem der Ansprüche 3 bis 6,
wobei die Spiegelschicht (5) unmittelbar an den Träger (3) angrenzt.

8. Halbleiterchip nach mindestens einem der vorhergehenden Ansprüche,
wobei die Spiegelschicht (5) unmittelbar an den Dünnfilm-Halbleiterkörper (2) angrenzt.

9. Halbleiterchip nach mindestens einem der Ansprüche 3 bis 8,
wobei der Dünnfilm-Halbleiterkörper (2) mittels der Spiegelschicht (5) auf dem Träger (3) befestigt ist.

10. Halbleiterchip nach mindestens einem der vorhergehenden Ansprüche,
wobei die Spiegelschicht (5) elektrisch leitend ausgeführt ist.

11. Halbleiterchip nach mindestens einem der vorhergehenden Ansprüche,
wobei die Spiegelschicht (5) metallisch ausgeführt ist oder eine Legierung mit mindestens einem Metall aufweist.

12. Halbleiterchip nach mindestens einem der vorhergehenden Ansprüche,
wobei die Spiegelschicht (5) für im aktiven Bereich (4) zu erzeugende Strahlung (41, 42, 43) eine Reflektivität von 90% oder weniger aufweist.

13. Halbleiterchip nach mindestens einem der vorhergehenden Ansprüche,
wobei der Braggspiegel (6) für im aktiven Bereich (4) zu erzeugende Strahlung (41, 42, 43) eine Reflektivität von 90% oder weniger aufweist.

14. Halbleiterchip nach mindestens einem der vorhergehenden Ansprüche,
wobei der Halbleiterchip (1) resonatorfrei betrieben ist.

15. Halbleiterchip nach mindestens einem der vorhergehenden Ansprüche,
wobei der Abstand des aktiven Bereichs (4) vom Braggspiegel (6) größer ist als der Abstand des aktiven Bereichs von einer dem Braggspiegel abgewandten Oberfläche (14) des Dünnfilm-Halbleiterkörpers (2).

16. Halbleiterchip nach mindestens einem der vorhergehenden Ansprüche,
wobei die Spiegelschicht (5) großflächig elektrisch leitend mit dem Dünnfilm-Halbleiterkörper (2) verbunden ist.

## Claims

1. Radiation-emitting semiconductor chip (1) comprising a thin-film semiconductor body (2) which has a semiconductor layer sequence comprising an active region (4) suitable for generating radiation, and a mirror layer (5) arranged on the thin-film semiconductor body, wherein the semiconductor chip comprises a Bragg mirror (6), the Bragg mirror and the mirror layer are arranged on the same side of the active region, and wherein the semiconductor chip (1) is designed for generating incoherent radiation,
**characterized in that** a semiconductor contact layer (7) is arranged between the mirror layer (5) and the Bragg mirror (6).

2. Semiconductor chip according to Claim 1,
wherein
the Bragg mirror (6) is monolithically integrated into the semiconductor layer sequence of the thin-film semiconductor body (2).

3. Semiconductor chip according to Claim 1 or 2,
wherein
the thin-film semiconductor body (2) is arranged on a carrier (3), and the mirror layer (5) is arranged between the carrier and the thin-film semiconductor body.

4. Semiconductor chip according to Claim 3,
wherein
the Bragg mirror (6) is arranged between the active region (4) and the carrier (3).

5. Semiconductor chip according to at least one of the preceding claims,
wherein
the Bragg mirror (6) is arranged between the active region (4) and the mirror layer (5).

6. Semiconductor chip according to at least one of the preceding claims,
wherein
the semiconductor chip (1) is free of a growth substrate (13) of the semiconductor layer sequence of the thin-film semiconductor body (2).

7. Semiconductor chip according to at least one of Claims 3 to 6,
wherein
the mirror layer (5) directly adjoins the carrier (3).

8. Semiconductor chip according to at least one of the preceding claims,
wherein
the mirror layer (5) directly adjoins the thin-film semiconductor body (2).

9. Semiconductor chip according to at least one of Claims 3 to 8,
wherein
the thin-film semiconductor body (2) is fixed on the carrier (3) by means of the mirror layer (5).

10. Semiconductor chip according to at least one of the preceding claims,
wherein
the mirror layer (5) is embodied in an electrically conductive fashion.

11. Semiconductor chip according to at least one of the preceding claims,
wherein
the mirror layer (5) is embodied in a metallic fashion or comprises an alloy comprising at least one metal.

12. Semiconductor chip according to at least one of the preceding claims,
wherein
the mirror layer (5) has a reflectivity of 90% or less for radiation (41, 42, 43) to be generated in the active region (4).

13. Semiconductor chip according to at least one of the preceding claims,
wherein
the Bragg mirror (6) has a reflectivity of 90% or less for radiation (41, 42, 43) to be generated in the active region (4)

14. Semiconductor chip according to at least one of the preceding claims,
wherein
the semiconductor chip (1) is operated in a resonator-free fashion.

15. Semiconductor chip according to at least one of the preceding claims,
wherein
the distance between the active region (4) and the Bragg mirror (6) is greater than the distance between the active region and a surface (14) of the thin-film semiconductor body (2) facing away from the Bragg mirror.

16. Semiconductor chip according to at least one of the preceding claims,
wherein
the mirror layer (5) is electrically conductively connected to the thin-film semiconductor body (2) over a large area.

## Revendications

1. Puce à semi-conducteur émetteur de lumière (1) comprenant un corps de semi-conducteur à film fin (2) qui présente une suite de couches de semi-conducteur ayant une zone (4) active appropriée pour produire un rayonnement et une couche-miroir (5) disposée sur le corps de semi-conducteur à film fin, dans laquelle la couche de semi-conducteur présente un miroir de Bragg (6), le miroir de Bragg et la couche-miroir sont disposés sur le même côté de la zone active, et dans laquelle la puce à semi-conducteur (1) est conçue pour produire un rayonnement incohérent,
**caractérisé en ce qu'**une couche de contact de semi-conducteur (7) est disposée entre la couche-miroir (5) et le miroir de Bragg (6).

2. Puce à semi-conducteur selon la revendication 1, dans laquelle le miroir de Bragg (6) est intégré de façon monolithique dans la suite de couches de semi-conducteur du corps de semi-conducteur à film fin (2).

3. Puce à semi-conducteur selon la revendication 1 ou 2, dans laquelle le corps de semi-conducteur à film fin (2) est disposé sur un support (3) et la couche-miroir (5) est disposée entre le support et le corps de semi-conducteur à film fin.

4. Puce à semi-conducteur selon la revendication 3, dans laquelle le miroir de Bragg (6) est disposé entre la zone active (4) et le support (3).

5. Puce à semi-conducteur selon au moins l'une des revendications précédentes, dans laquelle le miroir de Bragg (6) est disposé entre la zone active (4) et la couche-miroir (5).

6. Puce à semi-conducteur selon au moins l'une des revendications précédentes, dans laquelle la puce à semi-conducteur (1) est sans substrat de croissance (13) de la suite de couches de semi-conducteur du corps de semi-conducteur à film fin (2).

7. Puce à semi-conducteur selon au moins l'une des revendications 3 à 6, dans laquelle la couche-miroir (5) est délimitée directement sur le support (3).

8. Puce à semi-conducteur selon au moins l'une des revendications précédentes, dans laquelle la couche-miroir (5) est délimitée directement sur le corps de semi-conducteur à film fin (2).

9. Puce à semi-conducteur selon au moins l'une des revendications 3 à 8, dans laquelle le corps de semi-conducteur à film fin (2) est fixé sur le support (3) au moyen de la couche-miroir (5).

10. Puce à semi-conducteur selon au moins l'une des revendications précédentes, dans laquelle la couche-miroir (5) est conçue avec une conductibilité électrique.

11. Puce à semi-conducteur selon au moins l'une des revendications précédentes, dans laquelle la couche-miroir (5) est conçue métallique ou présente un alliage avec au moins un métal.

12. Puce à semi-conducteur selon au moins l'une des revendications précédentes, dans laquelle la couche-miroir (5) présente une réflectivité de 90 % ou moins pour le rayonnement (41, 42, 43) à produire dans la zone active (4).

13. Puce à semi-conducteur selon au moins l'une des revendications précédentes, dans laquelle le miroir de Bragg (6) présente une réflectivité de 90 % ou moins pour le rayonnement (41, 42, 43) à produire dans la zone active (4).

14. Puce à semi-conducteur selon au moins l'une des revendications précédentes, dans laquelle la puce à semi-conducteur (1) est exploitée sans résonateur.

15. Puce à semi-conducteur selon au moins l'une des revendications précédentes, dans laquelle la distance de la zone active (4) au miroir de Bragg (6) est supérieure à la distance de la zone active à une surface (14) du corps de semi-conducteur à film fin (2) détournée du miroir de Bragg.

16. Puce à semi-conducteur selon au moins l'une des revendications précédentes, dans laquelle la couche-miroir (5) est reliée au corps de semi-conducteur à film fin (2) avec une conductibilité électrique à grande surface.
